# EUROPEAN PATENT SPECIFICATION

(11) **EP 3 180 173 B1**
(45) Date of publication and mention of the grant of the patent: **07.04.2021**
(21) Application number: 14899839.6
(22) Date of filing: 15.08.2014
(51) Int. Cl.: B29C 33/38, B28B 7/34, B29C 33/40, B29C 33/42, B29C 33/44, B29C 33/52, B28B 19/00, E04G 9/10, B33Y 80/00, B33Y 10/00, E04C 2/04, B29C 64/106, B29C 64/209, E04C 2/32, E04C 2/40, G06F 30/13

(54) **METHOD FOR FABRICATING A COMPOSITE CONSTRUCTION ELEMENT**
VERFAHREN ZUR HERSTELLUNG EINES VERBUNDKONSTRUKTIONSELEMENTS
PROCÉDÉ PERMETTANT LA FABRICATION D'UN ÉLÉMENT DE CONSTRUCTION COMPOSITE

(43) Date of publication of application: 21.06.2017
(73) Proprietor: Laing O'Rourke Australia Pty Limited, North Sydney, New South Wales 2060 (AU)
(72) Inventor: GARDINER, James Bruce, Chippendale, New South Wales 2008 (AU)
(74) Representative: Latham, Stuart Alexander
(86) International application number: PCT/AU2014/000811
(87) International publication number: WO 2016/023060

(56) References cited:
- WO-A1-2014/127426
- WO-A2-2013/130760
- DE-A1- 4 110 176
- DE-U1- 29 504 838
- US-A- 4 241 126
- US-A- 5 590 454
- US-A- 5 900 180
- US-A1- 2006 003 144

## Description

### TECHNICAL FIELD

The present invention generally relates to fabricating construction elements used to construct buildings or similar structures. In particular, the invention relates to casting material to form a composite construction element using a mould.

### BACKGROUND TO THE INVENTION

Casting of settable building materials, such as concrete, to form elements which are used to construct buildings, or which form an integral part of a building, has been performed for a considerable length of time. Casting these materials typically involves constructing a mould having a cavity with inverse geometry to the desired geometry of a construction element. Substantially liquid building material, such as concrete, is poured into the cavity and set (cured), solidifying the building material within the cavity and forming a construction element having the desired geometry. The construction element is typically then removed from the mould.

A variation of this process involves securing veneer tiles, such as brick, stone, marble or glass blocks, to the mould prior to casting the construction element. The arrangement of the veneer tiles is typically determined by inserting the tiles into a 'layout' mat or template, being a structure defining apertures for receiving and retaining the tiles, which is secured to one or more surfaces of the mould. The liquid building material is subsequently poured over the tiles and cured. Once the building material has solidified, the mould is removed, exposing a composite construction element having the veneer tiles embedded in respective one or more surfaces of the cast component.

Due to facing material generally comprising substantially planar objects such as tiles, known composite construction elements are typically cast between planar mould surfaces to form a substantially planar panel, known as a 'faced', 'slip' or 'veneered' precast panel, and used as a façade on exterior walls of buildings. However, this limits the application of such panels to forming planar walls only, as the process inherently limits the geometry of the composite construction element able to be cast in a mould having planar surfaces only.

An example of a non-planar veneered cast structure is disclosed in US patent no. 4,241,126 entitled "Process of producing a composite element comprising sheet members secured to a support and such composite elements", filed on 31 October 1978. This discloses a method for producing a composite element comprising planar, reflective sheets rigidly secured to a support structure. The method involves arranging the sheets on a jig in a predetermined orientation relative to one another and pouring fluid, settable material over the sheets. The material is then allowed to set to form the support structure.

In instances where a geometrically complex cast structure is required, it is known to construct a mould having the necessary complex geometry, for example, by milling laminated MDF sheets to have the desired geometry. However, this can raise a further issue when casting geometries having 'over-hanging' ('undercut') surfaces, which result in the mould becoming engaged with the over-hanging surfaces once solidified, meaning that it is difficult or impossible to remove the mould from the construction element. Further, as 'layout mats' and the like are typically configured as planar sheets, securing such mats to complex geometry moulds, and also reliably retaining veneer tiles in the mat throughout the casting process, can prove difficult or impossible.

Past solutions to overcome the issue of releasing a mould from a cast construction element having over-hanging surfaces have involved using a complex, multi-part mould which is disassembled to release the construction element, or using a consumable mould which is destroyed after the construction element has solidified to release the element, for example, by breaking the mould apart. However, these solutions are often expensive due to the complexity of the multi-part mould or the quantity of mould material consumed fabricating and subsequently destroying the mould, which also potentially creates large volumes of waste material. Also, both of these solutions can require a considerable length of time and/or energy to construct the mould and remove the mould from the cast element.

Accordingly, it would be useful to provide a more efficient, sustainable or cost effective method for fabricating a composite construction element having one or more objects embedded therein, and particularly for fabricating such a composite construction element which has complex geometry.

### SUMMARY OF THE INVENTION

According to one aspect of the invention there is provided a method for fabricating a composite construction element using a computer-controlled apparatus according to claim 1.

In the context of this specification, 'construction element' refers generally to any object used in conjunction with other elements to construct a structure and in particular, refers to elements used to construct buildings, bridges and similar structures, such as sculptures, landscape features or structural retaining walls. Construction elements which are attached to a larger structure, or which form an entire, discrete structure, are considered within the scope of 'construction element'.

Throughout this specification the term 'mould' refers generally to an article used to shape the structure of another material during the transition of the material from a fluid or a flexible matrix, to a substantially rigid structure. Such 'moulds' include a formwork, buck, core or mandrel.

For the purposes of this specification, 'composite material' refers generally to fibre-reinforced polymer composite materials, including thermoplastic composites, short fibre thermoplastics, long fibre thermoplastics and long fibre-reinforced thermoplastics. The composite material may include fibres formed from natural (organic) or synthetic (non-organic) materials. However, the term composite may also include reference to metal matrix or ceramic matrix composite materials.

### BRIEF DESCRIPTION OF THE DRAWINGS

Preferred embodiments of the invention will now be described, by way of example only, with reference to the accompanying drawings in which:
Figure 1 is a perspective view of an apparatus fabricating a mould;
Figure 2 is a perspective view of an alternative apparatus fabricating an alternative mould;
Figure 3 is a cross-section view of a further alternative apparatus fabricating an alternative mould;
Figure 4 is a perspective view of the apparatus in Figure 1 fabricating an alternative mould and a construction element fabricated with the mould;
Figure 5 is a perspective view of a further alternative mould and a composite construction element fabricated with the mould;
Figure 6 is a perspective, cross-section view of another mould having a plurality of tiles retained therein;
Figure 7 is a perspective view of a further alternative mould having a plurality of bricks retained therein;
Figure 8 is a perspective view of a further alternative mould having signage and electrical components retained therein;
Figure 9A and 9B are perspective views of different moulds having a plurality of blocks retained therein and webs secured between blocks;
Figures 10A and 10B are a cross-section views of a plurality of blocks secured in a surface of a further alternative mould;
Figure 11 is a perspective view of a planar panel having a plurality of cutting paths marked thereon;
Figure 12A and 12B are cross-section views of an alternative planar panel;
Figure 13 is a perspective view of a non-planar panel having a plurality of cutting paths marked thereon and blocks cut from the panel; and
Figures 14A-14F are cross-section views of a further alternative panel and mould.

### DETAILED DESCRIPTION OF PREFERRED EMBODIMENTS

The present disclosure relates to a method for fabricating a composite construction element using a computer-controlled apparatus, the method comprising the steps of receiving, by the apparatus, computer instructions relating to a mould geometry, moving the apparatus and selectively fabricating build material in specific locations to fabricate a mould having one or more receiving portions dimensioned to receive one or more respective objects, the mould corresponding with the mould geometry, positioning the one or more objects in respective receiving portions, covering at least a portion of the mould and the one or more objects with settable material, and at least partially curing the settable material, thereby forming the composite construction element having the one or more objects embedded therein.

The computer instructions are typically derived from a digital three-dimensional (3D) model of the composite construction element or the mould, created in computer aided design (CAD) software. The 3D model is created by one or more of a user operating the CAD software and an algorithm configured to generate desired features of the composite construction element and/or mould being executed by the CAD software. Generally, the CAD data is derived as a result of a user modelling the composite construction element geometry, including the objects embedded therein (known as a digital 'buck'), within a virtual environment in the CAD software, and the CAD software calculating a digital mould geometry, being the inverse geometry of the buck which provides the necessary geometry to receive the objects and cast the construction element. Optionally, additional features of the mould, such as side-walls and the like which are required to define one or more cavities for receiving settable material, are added to the digital mould. The apparatus is then provided with computer instructions to direct the apparatus to fabricate the mould.

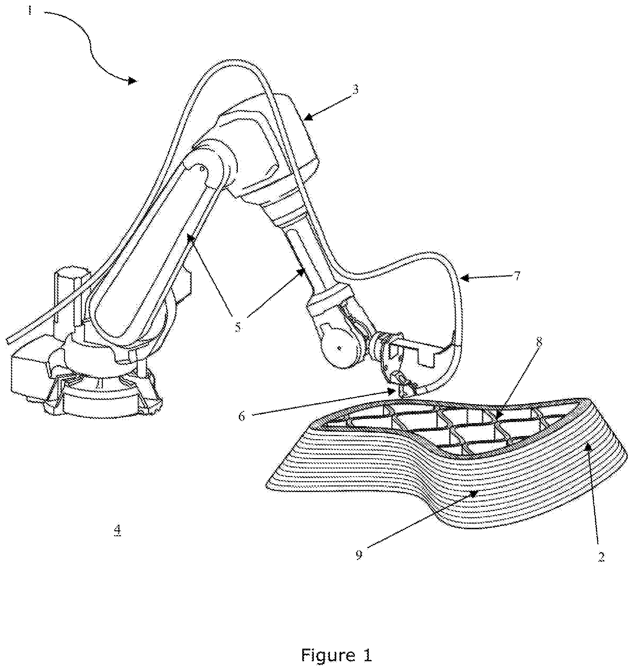

Figure 1 shows a computer-controlled apparatus 1 fabricating a mould 2. The apparatus 1 comprises a robotic arm 3 having a proximal end secured to a surface 4, the arm 1 having a plurality of sections 5 rotatably connected to each other around at least one axis, thereby allowing the arm 1 to move across a wide range. A material deposition head 6 is rotatably connected to a distal end of the arm 1. The material deposition head 6 is in fluid communication with a supply of material via a hose 7 and selectively deposits portions of the material responsive to the computer instructions. Whilst the apparatus 1 is shown having a single robotic arm 3, it will be appreciated that it may comprise a plurality of arms to allow larger moulds to be fabricated quickly, and that each arm may also be movable relative to the surface 4.

The apparatus 1 fabricates the mould 2 by moving the arm 3 and selectively depositing the material from the material deposition head 6, thereby forming one or more beads of material. The mould 2 is typically fabricated by depositing material in one or more beads, in successive layers, one on top of another extending away from the surface 4. Each layer may be formed from a plurality of beads or a single continuous bead. The mould 2 is typically fabricated as a hollow shell having a scaffold structure 8 contained therein, providing sufficient structural support for the shell. The exterior surfaces of the shell provide one or more casting surfaces 9, on which settable building material, for example, cementitious material such as concrete, is applied and cured, thereby forming the construction element. As shown in Figure 1, the casting surfaces 9 are configurable as three-dimensional surfaces, having geometry extending in all three dimensions. This may comprise curved, compound curved or faceted surfaces.

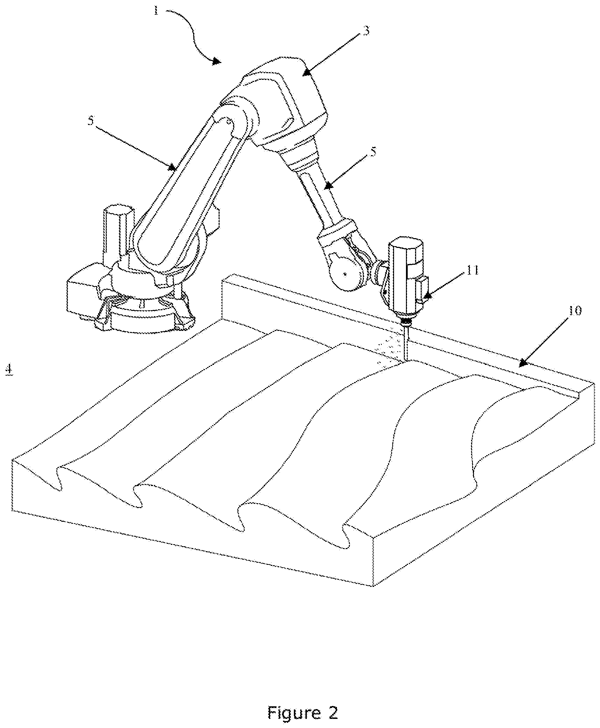

Figure 2 shows the apparatus 1 fabricating an alternative mould 10 by selectively removing material from the mould 10 with a milling spindle 11. This may be by the robotic arm 3 interchanging the material deposition head 6 for the milling spindle 10 or an alternative robotic arm 3 being provided with the milling spindle 10 or similar cutting apparatus. The arm 3 moves and selectively removes portion of material from the mould 10 responsive to computer instructions. The mould 10 may be milled by the apparatus 1 from a block of material to form the desired mould geometry, or this may be performed as a subsequent stage after the apparatus 1 has deposited material from the material deposition head 6, as shown in Figure 1. For example, in some instances, it may be desirable to rapidly deposit material to form the approximate mould 10 shape with the material deposition head 6 and then subsequently mill the mould 10 to refine the geometry of the mould 10.

Optionally, the apparatus 1 includes a 3D scanner (not shown), such as a near field sonar or infrared scanner, configured to scan the geometry of the mould 2, 10 and verify the geometry with the 3D model at predefined intervals during the fabrication process. When the 3D scanner detects variation from the 3D model beyond a predefined tolerance, computer instructions are executed by the apparatus 1 to adjust the geometry of the mould 2, 10 to be within the defined tolerance. For example, this may involve adding or removing material by selective deposition or milling.

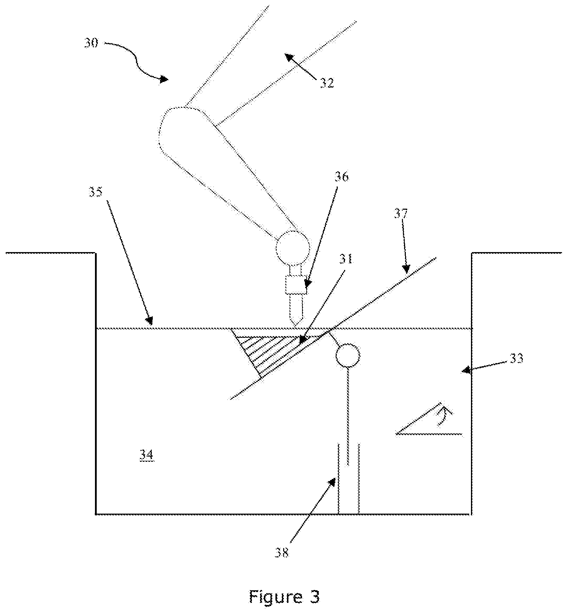

Figure 3 shows an alternative apparatus 30 fabricating a further alternative mould 31. The apparatus 30 comprises a first robotic arm 32 suspended above and movable relative to a reservoir 33 filled with a substantially liquid, curable material 34 forming a top surface 35. The first arm 32 has a material activation head 36 secured at an end thereof comprising one or more of an energy source (not shown) or a nozzle (not shown) in fluid communication with a chemical agent, both of which configured to rapidly cure the curable material 34 when exposed to the curable material 34.

The first arm 32 moves the material activation head 36 relative to the top surface 35 and selectively exposes the top surface 35 to the energy source and/or chemical agent, thereby curing portions of curable material 34 in contact with the top surface 35 to form at least one bead of solidified material, responsive to the computer instructions. A platform 37 is movably disposed within the reservoir 33 and supports the solidified beads of material. The platform 37 is connected to a second robotic arm 38 in the reservoir 22 and is movable, and optionally also rotatable around at least one axis, thereby repositioning the solidified beads of material relative to the top surface 35. The mould 31 is fabricated by the apparatus 30 selectively solidifying material 34 to form one or more beads, arranged in one or more layers, substantially similarly to the fabrication process described above.

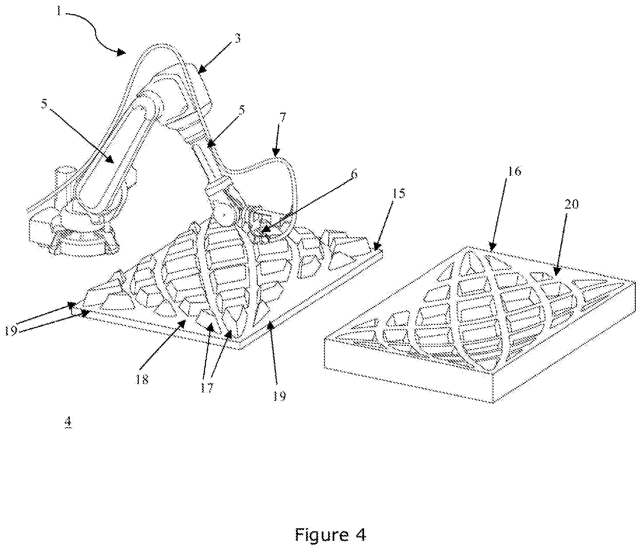

Figure 4 shows the apparatus 1 selectively depositing material to fabricate an alternative mould 15, and a construction element 16 which has been fabricated by casting settable material on the mould 15. The mould 15 has a plurality of projections 17 extending from a curved surface 18. The construction element is fabricated by affixing planar shutters (not shown) to edges 19 of the mould to form a cavity between the shutters, projections 17 and curved surface 18. Settable material is poured into the cavity and at least partially cured, forming an at least partly solid construction element 16. The mould 15 and shutters are then removed from the construction element 17, revealing a portion 20 having inverse geometry to the projections 17 and curved surface 18.

In instances where the mould 15 geometry has undercut surfaces, the mould 15 is typically removed by heating the mould 15, causing the mould to melt and drain away from the construction element 16, or by exposing the mould 15 to a fluid, such as by spraying with or submerging in a liquid, causing the mould 15 to melt and/or dissolve. Further, it may be preferable to remove only part of the mould 15 from the construction element 16, for example, where the mould 15 may be useful to leave in place as a structural, functional (e.g. insulation) or decorative component of the construction element 17, in which case, the mould is only partly removed from the construction element 17.

The mould material is preferably meltable, such as a wax compound, configured to melt at a relatively low temperature, following which it may be collected and recirculated to the apparatus 1, and reused by the apparatus 1 to fabricate another mould. The material is preferably configured to melt at a temperature of less than 70°C to ensure that when heating the mould 15 and a cast, concrete construction element, such as element 16, engaged with the mould 15, that the heat does not degrade the structure of the concrete whilst curing, which could reduce the strength of the construction element 16.

Alternatively, the mould material is soluble, such as plaster, able to be dissolved and optionally, collected and recirculated to the apparatus 1. Similarly, the material may be dissolvable, such as foam, able to be dissolved with a chemical solution.

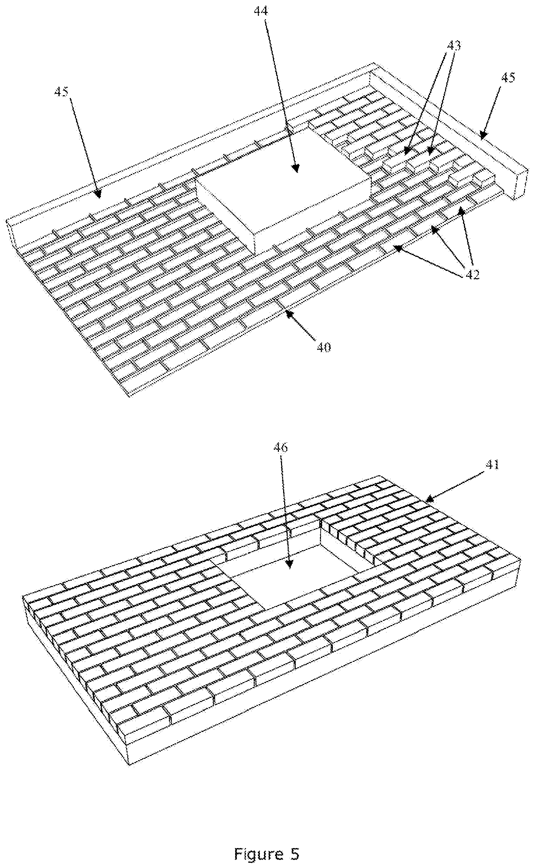

Figure 5 shows an alternative mould 40 and a composite construction element 41 fabricated with the mould 40. The mould 40 has been fabricated by one or more of the apparatus 1, 30 as described above. The mould 40 has a generally planar form and a plurality of recesses 42 arranged in a top surface thereof, each recess 42 dimensioned to receive a brick 43. Each brick 43 has a facing surface 47 arranged face down into the recess 42, the facing surface 47 being the surface which protrudes from or is otherwise visible on a composite construction element fabricated with the mould 40. A projection 44 extends from the top surface of the mould 40 and shutters 45 are arranged along two sides of the mould 40.

Whilst the shutters 45 are shown as separate parts to the mould 40, it will be appreciated that the mould 40 may be fabricated having integral shutter surfaces along each side of the mould 40. Furthermore, whilst recesses 42 are shown, it will be appreciated that equivalent structures may be provided in the top surface in order to provide a receiving portion to receive, and possibly also securely retain, the bricks 43 therein. For example, the mould 42 may comprise a plurality of apertures (not shown) dimensioned to receive a peripheral region of each brick 43 and frictionally engage with the peripheral region. Alternatively, the bricks 43 may comprise a lip around a periphery of the facing surface 47 and the apertures engage with the lip. Similarly, the mould 43 may comprise an array of pegs or ribs (not shown) extending from the top surface, whereby the pegs or ribs are arranged such that a brick is retained therebetween.

The composite construction element 41 is fabricated by the bricks 43 being selectively positioned in the recesses 42 such that the facing surface 47 of each brick 43 is at least partly in contact with a surface of a respective recess 42, shutters 45 being affixed along all four sides of the mould 40 to form a cavity between the top surface, bricks 43 and shutters 45, and settable material being introduced into the cavity. The settable material is cured and the mould 40 and shutters 45 removed from the cured material, thereby revealing the composite construction element 41 comprising the cured, settable material and the bricks 43 embedded in a surface thereof, with the facing surface 47 of each brick 43 visible on a surface of the composite construction element 41. The composite construction element 41 also has an aperture 46 therethrough, corresponding with the projection 44 of the mould 40, allowing further components, such as a window, to be secured in the aperture 46.

The bricks 43 may be positioned manually by a user or, more typically, placed by an apparatus, such as apparatus 1 having a mechanical gripper (not shown) or vacuum head (not shown) interchanged with the material deposition head 6, responsive to further computer instructions indicating a desired brick arrangement. For example, some of the bricks 43 may have a glazed facing surface and others may have a matt finish facing surface, and the apparatus 1 be directed by the computer instructions to position glazed and non-glazed bricks in a specific arrangement to form an image or pattern. In either case, the facing surface 47 of each brick 43 is positioned face-down against a surface of a respective recess 42 to ensure that the facing surface 47 is visible on an exterior surface of the composite construction element 41, after the element 41 has been cast against the mould 40. It will be appreciated that bricks are merely an example of various materials able to be secured to the mould 40 and consequently embedded in the composite construction element 41, and that other similar blocks of material, such as blocks of glass, stone (such as marble), metal, plastic and the like may be substituted for the bricks 43.

On occasions where the bricks 43 are manually placed in the recesses 42, an apparatus may mark specific recesses to indicate where particular bricks 43 should be placed. For example, the apparatus 1 may further comprise a nozzle (not shown) in communication with an ink supply and selectively spray the ink in specific recesses to indicate glazed bricks 43 should be positioned therein.

The composite construction element 41 is typically fabricated by a conventional casting process, whereby the settable material is poured or pumped into the cavity and at least partially cured. Alternatively, the settable material may be sprayed into the cavity, potentially in a plurality of successive layers. This allows the composition of the settable material in each layer to be varied, thereby further affecting the properties of the composite construction element 41. For example, a first layer may comprise glass-fibre reinforced concrete (GRC), to provide a rigid shell and strong bond to the bricks 43, a second layer may comprise foam for thermal/acoustic insulation, and a third layer comprise a cementitious material, such as concrete or plaster. Similarly, the settable material may be selectively deposited by the apparatus 1 (or similar '3D printer' apparatus).

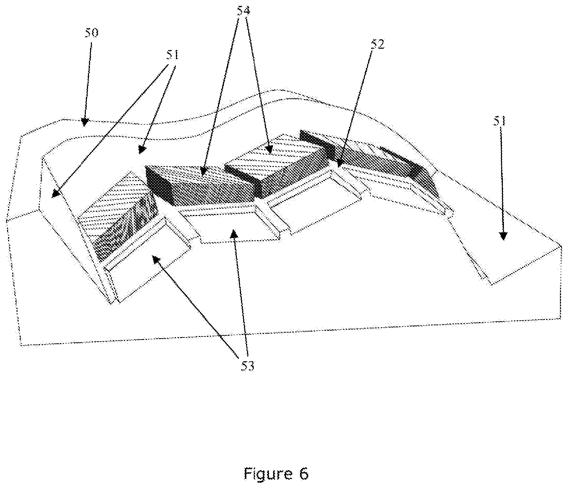

Figure 6 shows a cross-section of further alternative mould 50 fabricated by one or more of the apparatus 1, 30. The mould 50 defines a cavity between side-walls 51 and a base surface 52, the base surface 52 being a three-dimensionally curved surface. The base surface 52 has a plurality of recesses 51 therein dimensioned to engage with one or more tiles 52. Each recess 51 has a peripheral region dimensioned to provide a frictional engagement with a respective peripheral region of a tile 52, thereby firmly securing the tile 52 to the mould 50 and substantially preventing settable material permeating into the recess during a casting process, which could affect the appearance and/or structure of the facing surface of each tile 52. As described above, a composite construction element (not shown) can be fabricated with the mould 50 and tiles 52 by introducing settable material into the cavity and at least partially curing the settable material. When the mould 50 is removed, a composite construction element having corresponding geometry to the cavity is revealed, in which the tiles 52 are embedded in a complementary three-dimensionally curved surface to the base surface 52.

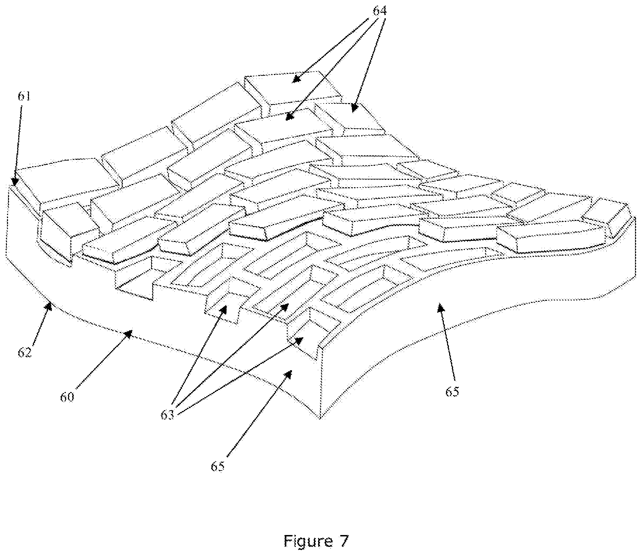

Figure 7 shows a further alternative mould 60 fabricated by one or more of the apparatus 1, 30. The mould 60 comprises a substantially constant thickness panel having a compound curved top surface 61 and bottom surface 62, thereby forming a non-planar panel. The top surface 61 has an array of recesses 63 therein, each recess 63 dimensioned to receive a single brick 64. A composite construction element (not shown) can be fabricated with the mould 60 and bricks 64 by securing shutters (not shown) to the side-walls 65 of the mould 60 to form a cavity between the shutters, top surface 61 and bricks 64, and introducing settable material into the cavity. The settable material is at least partially cured and the mould 60 and shutters removed therefrom, exposing the composite construction element having the bricks 64 embedded in an inverse, compound curved surface to the top surface 61.

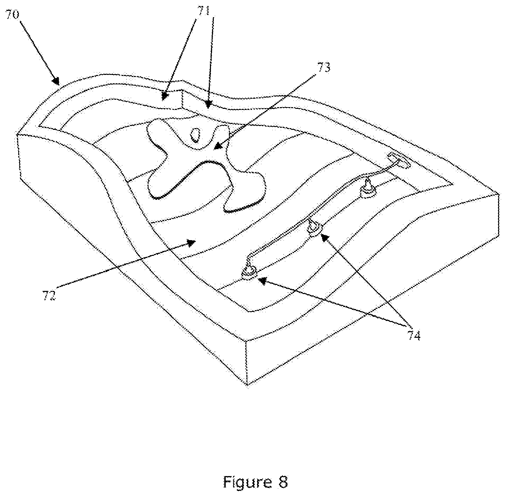

Figure 8 shows another mould 70 fabricated by one or more of the apparatus 1, 30. The mould 70 defines a cavity between side-walls 71 and a base surface 72. The base surface 72 has a plurality of recesses (not visible) adapted to receive and retain various signage and electrical components. For example, sign 73 comprises a metal plate having a facing surface (not shown) displaying text and/or graphics, which is placed into a recess. Light fittings 74 each have a light emitting surface which is also placed into a respective recess. The fittings 74 are pre-wired to each other and to a junction box 75 which is secured to a side-wall 71. A composite construction element (not shown) is fabricated with the mould 70 by spraying one or more layers of settable material into the cavity, covering the sign 73 and light fittings, and at least partly filling the cavity. Once the settable material has at least partially cured, the mould 70 is removed, exposing a composite construction element having complimentary surfaces to the base surface 72 and side-walls 71, and having the sign 73 and light fixtures 74 embedded therein.

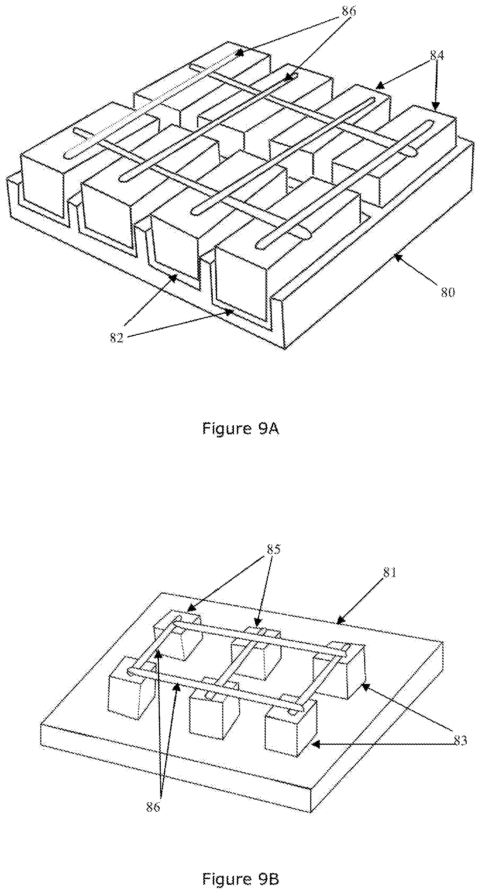

Figures 9A and 9B show two further alternative moulds 80, 81 fabricated by one or more of the apparatus 1, 30. Each mould 80, 81 defines a substantially planar panel having a plurality of recesses 82, 83 dimensioned to receive various blocks of material 84, 85. Following the insertion of the blocks 84, 85 into the recesses 81, 82 one or more webs 86 are secured to at least two blocks 84, 85. When settable material is applied over the blocks 84, 85, webs 86 and mould 80, 81, the webs 86 limit or prevent blocks 84, 85 moving relative to each other, thereby assisting retaining the blocks 84, 85 in the desired arrangement during the fabrication process. Preferably, a plurality of webs 86 are applied to an array of blocks 84, 85, each web 86 being secured to at least two blocks 84, 85. Further, the webs 86 may be arranged to form a grid or network, to further enhance the rigidity of the array of blocks 84, 85. Typically, the webs 86 are formed from a composite material, such as carbon fibre matting or tape, and adhered to each block 84, 85. The webs 86 may further comprise integrated electrical components, such as fibre optic cables, to allow for monitoring of the structure of a resulting composite construction element to be performed.

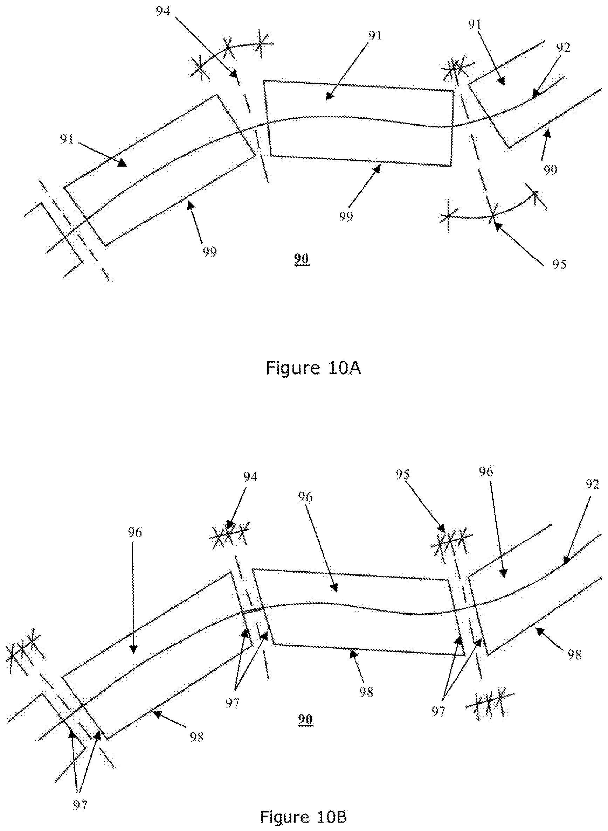

Figure 10A shows a cross-section view of a further alternative mould 90, fabricated by one or more of the apparatus 1, 30, having first blocks 91 embedded in recesses in a surface 92 thereof, and Figure 10B shows a cross-section view of the mould 90 having second blocks 96 embedded in recesses in the surface 92.

In Figure 10A, each of the first blocks 91 have a rectangular cross-sectional profile, as is convention with building material blocks, such as bricks. The blocks 91 have been secured in recesses in the surface 92, which has a curved cross-sectional profile having two distinct curved corners being a convex corner 94 and concave corner 95. The blocks 91 are arranged at regular intervals along the surface 92 and extend substantially perpendicular to the surface 92. This results in irregular gaps forming between the blocks 91 at the corners. For example, at the convex corner 94 a larger gap is formed, as the blocks 91 extend away from each other, and at the concave corner 95, a smaller gap is formed, as the blocks 91 extend towards each other. For some applications, this is an undesirable arrangement as this will result in uneven gaps being formed between a facing surface 99 of each block 91 when the blocks 91 are embedded in a composite construction element (not shown) fabricated using the mould 90 and blocks 91.

In Figure 10B, each of the second blocks 96 have an irregular cross-sectional profile, whereby at least one side-wall 97 of each block 96 is arranged in a non-perpendicular orientation relative to a facing surface 98. In particular, the orientation of at least a portion of each side-wall 97 is arranged to be perpendicular to an intersection of the side-wall 97 with a virtual, continuous surface, corresponding with the surface 92 yet excluding the recesses for the blocks 96.

The arrangement of the side-walls 97 in this way results in the gap between blocks 96 being maintained at a substantially constant dimension along the curved surface 92, consequently resulting in constant gaps between the facing surface 98 of each block 96 when the blocks 96 are embedded in a composite construction element (not shown) fabricated using the mould 90 and blocks 96.

The blocks 96 are shaped in this way either by cutting larger blocks to the required profile or by fabricating blocks having the required profile. For example, the apparatus 1 may also have cutting means, such as a water-jet cutter or a saw, and cut bricks or other blocks of material to the desired geometry, responsive to further computer instructions. Alternatively, the blocks 96 are fabricated having the required geometry, for example, by the apparatus 1 selectively depositing block material to fabricate each block 96.

The geometry of blocks 96 and in particular, the arrangement of side-walls 97 relative to facing surfaces 98, may be calculated due to the facing surfaces 98 being modelled within the 3D model corresponding with the mould 90. This would involve defining a desired quantity and geometry of facing surfaces 98, including separation distance between facing surfaces 98 and insertion depth of the facing surfaces 98 into the mould 90, being offset from surface 92. Once the position of the facing surfaces 98 has been established relative to the surface 92, boundary surfaces (not shown) are arranged around the periphery of each facing surface 98 and orientated to have at least a portion arranged perpendicular to the surface 92 at the intersection of the boundary surface and the surface 92. The geometry of the boundary surfaces therefore corresponds with the required side-wall 97 geometry and allows further computer instruction to be derived therefrom, the further computer instructions directing the apparatus 1 (or other suitable apparatus) to shape the blocks 96 accordingly.

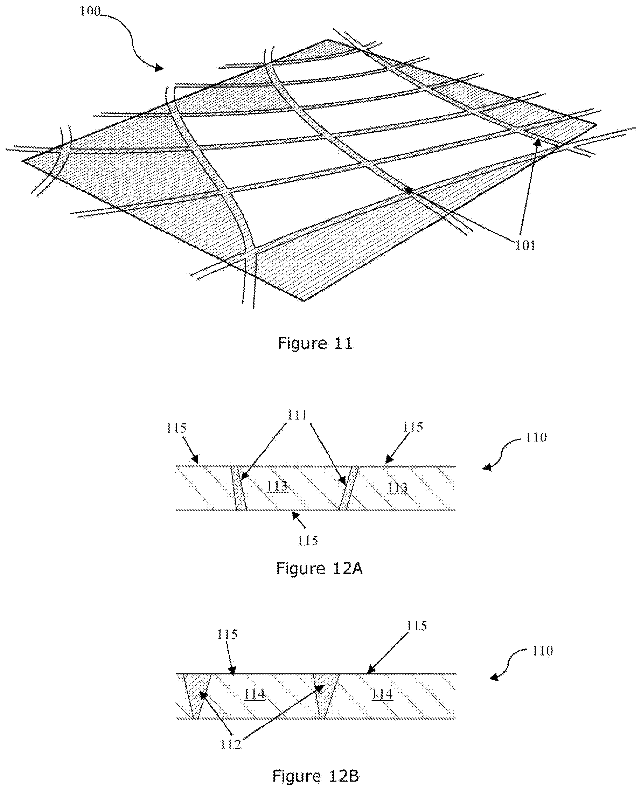

Figure 11 shows a substantially planar panel 100 of block material. The panel 100 has a plurality of cutting paths 101 marked thereon, providing an example of how the apparatus 1 (or other apparatus) may cut a large sheet of material into a plurality of blocks having the necessary geometry to conform to a surface of a mould (not shown) and maintain a constant separation distance between blocks, as described in relation to Figure 10B.

Figures 12A and 12B show cross-section views of an alternative planar panel 110 having various cutting paths 111, 112 marked thereon, indicating the regions which the apparatus 1 would cut in order to obtain blocks 113, 114 having the necessary geometry to conform to a mould surface (not shown) and maintain a constant separation distance between blocks 113, 114. Further, the geometry of each block 113, 114 is calculated such that a facing surface 115 on each block 113, 114 is a constant dimension, in order maintain the appearance of regular 'brick' faces having constant gaps therebetween protruding from or embedded in a curved surface of a construction element. Alternatively, the geometry of the facing surface 115 (or the gap between facing surfaces 115) may be calculated to gradually increase from one block 113, 114 to another, to provide a gradient of facing surface 115 dimensions across a surface of a resulting composite construction element.

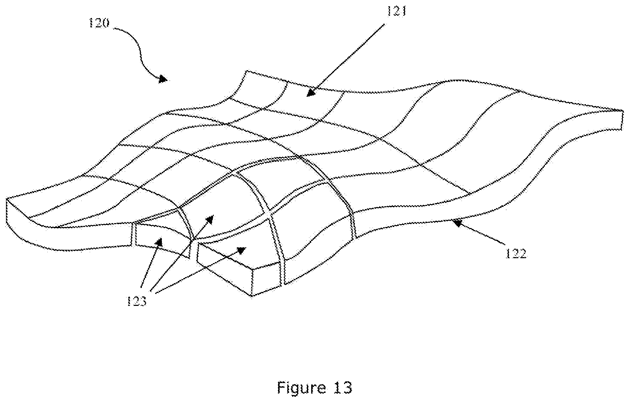

Figure 13 shows a non-planar panel 120 fabricated by being cast between two moulds (not shown), or by being milled from a larger panel, thereby forming a compound curved top surface 121 and compound curved bottom surface 122. The panel 120 has a plurality of cutting paths marked thereon, indicating where the panel 120 would be cut to form a plurality of blocks 123. The blocks 123 are then positioned in respective recesses in a further mould (not shown), fabricated using one or more of the apparatus 1, 30, and used to fabricate a composite construction element (not shown) as described above, thereby embedding the blocks 123 in the construction element and providing substantially continuous, compound curved facing surface formed from the top surface 121 or bottom surface 122. This approach is particularly useful where the panel 120 is formed from a high value material, such as stone facing, and the remainder of the composite construction element, i.e. the cast portion, is formed from a low value material, such as concrete. This allows the panel 120 to be fabricated having a relatively low thickness dimension, reducing the material required, and used as a facing for low value material.

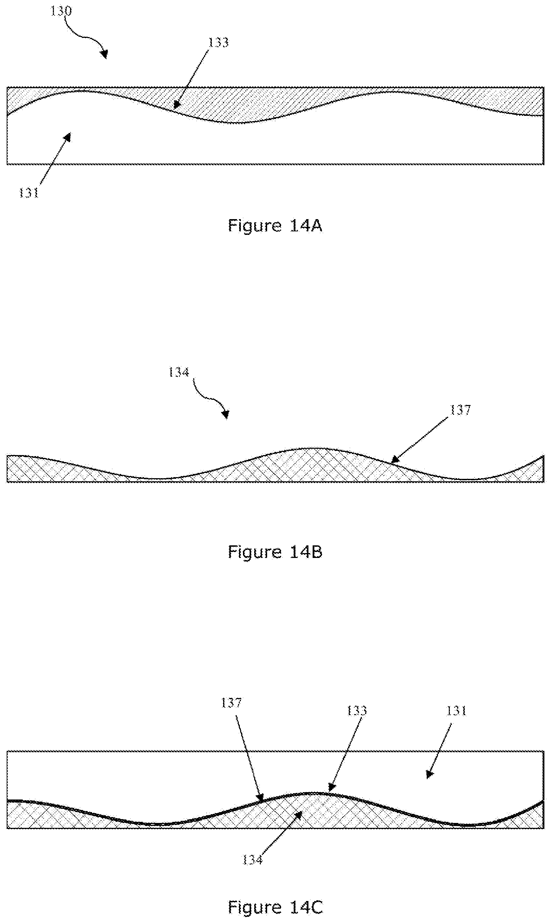

Figures 14A-14E show five stages of processing a panel 130 of material to fabricate a plurality of blocks 135 formed from the material having a specific, three-dimensional surface profile 136. The blocks 135 are configured to subsequently be used to fabricate a composite construction element (not shown) having the surface profiles 136 as a facing surface.

In Figure 14A, the panel 130 is shown having a non-hatched portion and hatched portion. The hatched portion is removed from the non-hatched portion by milling or other similar cutting means, resulting in a shaped panel 131 having an undulating surface 133.

Figure 14B shows a mould 134 fabricated by one or more of the apparatus 1, 30 having a top surface 137 having an inverse geometry to the undulating surface 133.

In Figure 14C, the shaped panel 131 is positioned on the mould 134 with the undulating surface 133 abutting the top surface 137.

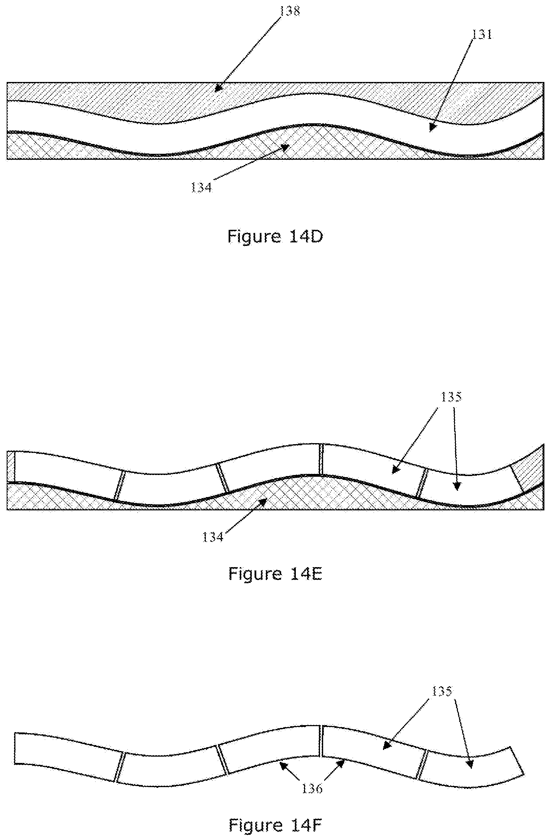

Figure 14D shows the shaped panel 131 having a further hatched portion 138, illustrating the portion of the panel 131 removed by a second milling operation material to form the blocks 135.

Figure 14E shows the blocks 135 positioned on the mould 134. Optionally, the blocks 135 may be positioned in respective recesses (not shown) in the mould 134. In either case, settable material may be applied over the blocks 135 and mould 134 to fabricate a composite construction element (not shown) having the blocks 135 embedded therein.

Figure 14F shows the blocks 135 in isolation, each having a facing surface 136 formed from the undulating surface 133, thereby allowing the facing surfaces 136 to form a substantially continuous, undulating facing on the composite construction element.

## Claims

1. A method for fabricating a composite construction element (41) using a computer-controlled apparatus (1), the method including:
receiving, by the apparatus (1), computer instructions relating to a mould geometry;
moving the apparatus (1) and selectively fabricating build material in specific locations corresponding with the mould geometry to fabricate a mould (60), the mould (60) having one or more non-planar casting surfaces (61) and a plurality of receiving portions (63) arranged on the one or more non-planar casting surfaces (61), the receiving portions (63) dimensioned to receive and retain a plurality of objects (64) in specific positions;
positioning the plurality of objects (64) in respective receiving portions (63);
covering at least a portion of the mould (60) and the plurality of objects (64) with a settable material; and
at least partially curing the settable material, thereby forming the composite construction element (41) having the plurality of objects (64) embedded therein.

2. The method for fabricating a construction element (41) according to claim 1, wherein fabricating the plurality of receiving portions (63) further comprises arranging the receiving portions (63) to position the objects (64) in different orientations relative to each other.

3. The method for fabricating a composite construction element (41) according to claim 1 or 2, wherein each of the plurality of objects (64) have a facing surface (98), and wherein positioning the plurality of objects (64) further comprises positioning each facing surface (98) against the respective receiving portion (63).

4. The method for fabricating a composite construction element (41) according to claim 3, wherein each object (64) is a block of material (96), and each block (96) comprises sidewalls (97) extending from the facing surface (98), and wherein before positioning the plurality of objects (64) in the respective receiving portions (63), the method further comprises shaping at least one sidewall (97) of at least one of the blocks (96) to be non-perpendicular to the facing surface (98) responsive to further computer instructions relating to a virtual intersection of the at least one sidewall (97) with a surface (92) of the mould geometry.

5. The method for fabricating a composite construction element (41) according to claim 4, wherein shaping the at least one sidewall (97) further comprises shaping all of the side-walls (97) to be perpendicular to the surface (92) of the mould geometry at the virtual intersection.

6. The method for fabricating a composite construction element (41) according to claims 4 or 5, wherein the step of shaping the at least one sidewall (97) further comprises cutting the block (96) from one of a substantially planar panel (110) and a substantially non-planar panel (120).

7. The method for fabricating a composite construction element (41) according to any one of the preceding claims, wherein the step of fabricating the receiving portions (63) further comprises fabricating the receiving portions (63) having geometry configured to engage the objects (64), and the step of positioning the plurality of objects in the respective receiving portions (63) further comprises engaging a peripheral region of each object (64) with a peripheral region of the respective receiving portion (63).

8. The method for fabricating a composite construction element (41) according to any one of the preceding claims, wherein before covering at least a portion of the mould (60) and the plurality of objects (64) with the settable material, the method further comprises securing at least one web (86) to at least two objects (64).

9. The method for fabricating a composite construction element (41) according to any one of the preceding claims, wherein selectively fabricating the build material further comprises selectively depositing and selectively milling the build material.

10. The method for fabricating a composite construction element (41) according to any one of the preceding claims, wherein the method further comprises at least one of heating at least a portion of the mould (60) to a temperature above a melting point of the build material to melt the at least a portion of the mould (60), and exposing at least a portion of the mould (60) to a liquid configured to dissolve the at least a portion of the mould (60), thereby removing the at least a portion of the mould (60) from the composite construction element (41).

11. The method for fabricating a composite construction element (41) according to claim 10, wherein the method further comprises collecting the melted build material and recirculating the collected melted build material to the apparatus (1).

12. The method for fabricating a composite construction element (41) according to any one of the previous claims, wherein the build material is a wax compound.

13. The method for fabricating a composite construction element (41) according to any one of the preceding claims, wherein the step of covering the at least a portion of the one or more non-planar casting surfaces (61) and the plurality of objects (64) with the settable material further comprises at least one of pouring the settable material onto the mould (60) and the plurality of objects (64), and spraying the settable material onto the mould (60) and the plurality of objects (64).

14. The method for fabricating a composite construction element (41) according to claim 13, wherein the step of covering by spraying the at least a portion of the one or more non-planar casting surfaces (61) and the plurality of objects (64) with the settable material further comprises spraying a first settable material to form a first layer and spraying a second settable material to form a second layer.

15. The method for fabricating a composite construction element (41) according to claim 14, wherein the first settable material is a composite material and the second settable material is a cementitious material.

## Patentansprüche

1. Verfahren zur Herstellung eines Verbundbauelements (41) unter Verwendung einer computergesteuerten Vorrichtung (1), wobei das Verfahren umfasst:
das Empfangen von Computeranweisungen, die sich auf eine Formengeometrie beziehen, durch die Vorrichtung (1);
das Bewegen der Vorrichtung (1) und das selektive Herstellen von Aufbaumaterial an bestimmten Stellen, die der Formengeometrie entsprechen, um eine Form (60) herzustellen, wobei die Form (60) eine oder mehrere nicht ebene Gussoberflächen (61) und eine Mehrzahl von Aufnahmebereichen (63) aufweist, die auf der einen oder den mehreren nicht ebenen Gussoberflächen (61) angeordnet sind, wobei die Aufnahmebereiche (63) zum Aufnehmen und Halten einer Mehrzahl von Objekten (64) in bestimmten Positionen dimensioniert sind;
das Positionieren der Mehrzahl von Objekten (64) in jeweilige Aufnahmebereiche (63);
das Bedecken wenigstens eines Teils der Form (60) und der Mehrzahl von Objekten (64) mit einem aushärtbaren Material; und
das wenigstens teilweise Aushärten des aushärtbaren Materials, wodurch das Verbundbauelement (41) mit den darin eingebetteten Mehrzahl von Objekten (64) gebildet wird.

2. Verfahren zur Herstellung eines Bauelements (41) nach Anspruch 1, wobei die Herstellung der Mehrzahl von Aufnahmebereichen (63) ferner das Anordnen der Aufnahmebereiche (63) zum Positionieren der Objekte (64) in verschiedenen Orientierungen relativ zueinander umfasst.

3. Verfahren zur Herstellung eines Verbundbaumaterials (41) nach Anspruch 1 oder 2, wobei jedes der Mehrzahl von Objekten (64) eine zugewandte Fläche (98) aufweist und wobei das Positionieren der Mehrzahl von Objekten (64) ferner das Positionieren jeder zugewandten Fläche (98) gegen den jeweiligen Aufnahmebereich (63) umfasst.

4. Verfahren zur Herstellung eines Verbundbauelements (41) nach Anspruch (3), wobei jedes Objekt (64) ein Materialblock (96) ist und wobei jeder Block (96) Seitenwände (97) hat, die sich von der zugewandten Fläche (98) erstrecken, und wobei vor dem Positionieren der Mehrzahl von Objekten (64) in den jeweiligen Aufnahmebereichen (63) das Verfahren ferner das Formen wenigstens einer Seitenwand (97) von wenigstens einem der Blöcke (96) umfasst, so dass diese nicht senkrecht zu der zugewandten Fläche (98) ist, in Reaktion auf weitere Computeranweisungen, die sich auf einen virtuellen Schnittpunkt der wenigstens einen Seitenwand (97) mit einer Fläche (92) der Formengeometrie beziehen.

5. Verfahren zur Herstellung eines Verbundbauelements (41) nach Anspruch 4, wobei das Formen der wenigstens einen Seitenwand (97) ferner das Formen sämtlicher Seitenwände (97) umfasst, so dass diese an dem virtuellen Schnittpunkt senkrecht zur Oberfläche (97) der Formengeometrie sind.

6. Verfahren zur Herstellung eines Verbundbauelements (41) nach den Ansprüchen 4 oder 5, wobei der Schritt des Formens der wenigstens einen Seitenwand (97) ferner das Schneiden des Blocks (96) aus einer im Wesentlichen ebenen Platte (110) oder einer im Wesentlichen nicht ebenen Platte (120) umfasst.

7. Verfahren zur Herstellung eines Verbundbauelements (41) nach einem der vorangehenden Ansprüche, wobei der Schritt der Herstellung der Aufnahmebereiche (63) ferner die Herstellung der Aufnahmebereiche (63) mit einer Geometrie umfasst, die für den Eingriff mit den Objekten (64) gestaltet ist, und wobei der Schritt des Positionierens der Mehrzahl von Objekten in den jeweiligen Aufnahmebereichen (63) ferner umfasst, dass ein Peripheriebereich jedes Objekts (64) mit einem Peripheriebereich des jeweiligen Aufnahmebereichs (63) in Eingriff gebracht wird.

8. Verfahren zur Herstellung eines Verbundbauelements (41) nach einem der vorangehenden Ansprüche, wobei vor dem Bedecken wenigstens eines Teils der Form (60) und der Mehrzahl von Objekten (64) mit dem aushärtbaren Material das Verfahren ferner das Befestigen von wenigstens einem Steg (86) an wenigstens zwei Objekten (64) umfasst.

9. Verfahren zur Herstellung eines Verbundbauelements (41) nach einem der vorangehenden Ansprüche, wobei die selektive Herstellung des Aufbaumaterials ferner das selektive Aufbringen und selektive Fräsen des Aufbaumaterials umfasst.

10. Verfahren zur Herstellung eines Verbundbauelements (41) nach einem der vorangehenden Ansprüche, wobei das Verfahren wenigstens einen der folgenden Vorgänge umfasst: wenigstens ein Teil der Form (60) wird auf eine Temperatur über dem Schmelzpunkt des Aufbaumaterials erhitzt, um den wenigstens einen Teil der Form (60) zu schmelzen, und mindestens ein Teil der Form (60) wird einer Flüssigkeit ausgesetzt, die zum Auflösen der Form (60) ausgelegt ist, wodurch der wenigstens eine Teil der Form (60) von dem Verbundbauelement (41) entfernt wird.

11. Verfahren zur Herstellung eines Verbundbauelements (41) nach Anspruch 10, wobei das Verfahren ferner das Auffangen des geschmolzenen Aufbaumaterials und das Rückführen des aufgefangenen Aufbaumaterials zur Vorrichtung (1) umfasst.

12. Verfahren zur Herstellung eines Verbundbauelements (41) nach einem der vorangehenden Ansprüche, wobei das Aufbaumaterial eine Wachsmasse ist.

13. Verfahren zur Herstellung eines Verbundbauelements (41) nach einem der vorangehenden Ansprüche, wobei der Schritt des Bedeckens des wenigstens einen Teils der einen oder mehreren nicht planaren Gussoberflächen (61) und der Mehrzahl von Objekten (64) mit dem aushärtbaren Material ferner mindestens eine der folgenden Vorgänge umfasst: das Gießen des aushärtbaren Materials auf die Form (60) und die Mehrzahl von Objekten (64) und das Aufsprühen des aushärtbaren Materials auf die Form (60) und die Mehrzahl von Objekten (64).

14. Verfahren zur Herstellung eines Verbundbauelements (41) nach Anspruch 13, wobei der Schritt des Bedeckens durch Aufsprühen des aushärtbaren Materials auf den wenigstens einen Teil der einen oder mehreren nicht planaren Gussoberflächen (61) und der Mehrzahl von Objekten (64) ferner das Aufsprühen eines ersten aushärtbaren Materials zum Bilden einer ersten Schicht und das Aufsprühen eines zweiten aushärtbaren Materials zum Bilden einer zweiten Schicht umfasst.

15. Verfahren zur Herstellung eines Verbundbauelements (41) nach Anspruch 14, wobei das erste aushärtbare Material ein Verbundmaterial und das zweite aushärtbare Material ein zementartiges Material ist.

## Revendications

1. Procédé de fabrication d'un élément de construction composite (41) en utilisant un appareil (1) commandé par ordinateur,
le procédé consistant à :
- recevoir par l'appareil (1), les instructions d'ordinateur concernant la géométrie de moule,
- déplacer l'appareil (1) et fabriquer sélectivement du matériau de construction à des emplacements spécifiques correspondant à la géométrie des moules, pour fabriquer un moule (60), ce moule (60) ayant une ou plusieurs surfaces de coulées (61), non planes et un ensemble de parties réceptrices (63) organisées sur une ou plusieurs des surfaces de coulées (61) non planes, les parties réceptrices (63) étant dimensionnées pour recevoir et retenir un ensemble d'objets (64) dans des positions spécifiques,
- positionner l'ensemble des objets (64) dans les parties réceptrices (63),
- couvrir au moins une partie du moule (60) et l'ensemble des objets (64) avec une matière durcissable, et
- faire durcir au moins en partie la matière durcissable en formant ainsi l'élément de construction composite (41), intégrant l'ensemble des objets (64).

2. Procédé de fabrication d'un élément de construction (41) selon la revendication 1,
selon lequel
fabriquer l'ensemble des parties réceptrices (63) consiste en outre à arranger les parties réceptrices (63) à la position des objets (64) selon différentes orientations les unes par rapport aux autres.

3. Procédé de fabrication d'un élément de composite (41) selon la revendication 1 ou 2,
selon lequel
chacun des objets de l'ensemble d'objets (64) a une surface de dessus (98), et
selon lequel
positionner l'ensemble des objets (64) consiste en outre à positionner chaque surface de dessus (98) contre la partie réceptrice (63) respective.

4. Procédé de fabrication d'un élément de construction (41) selon la revendication 3,
selon lequel
- chaque objet (64) est un bloc de matière (96) et chaque bloc (96) a des parois latérales (97) à partir de la surface de dessus (98), et
- avant de positionner l'ensemble des objets (64) dans les parties réceptrices (63) respectives, le procédé consiste en outre à mettre en forme au moins une paroi latérale (97) d'au moins l'un des blocs (96) pour ne pas être perpendiculaire à la surface de dessus (98) en fonction d'autres instructions d'ordinateur concernant l'intersection virtuelle d'au moins une paroi latérale (97) avec une surface (92) de la géométrie du moule.

5. Procédé de fabrication d'un élément de construction (41) selon la revendication 4,
selon lequel
la mise en forme d'au moins une paroi latérale (97) consiste en outre à mettre en forme toutes les parois latérales (97) pour qu'elles soient perpendiculaires à la surface (92) de la géométrie des moules à l'intersection virtuelle.

6. Procédé de fabrication d'un élément de construction (41) selon les revendications 4 ou 5,
selon lequel
l'étape de mise en forme d'au moins une paroi latérale (97) consiste en outre à découper le bloc (96) à partir d'un panneau (110) pratiquement plan et d'un panneau pratiquement non plan (120).

7. Procédé de fabrication d'un élément de construction (41) selon l'une quelconque des revendications précédentes,
selon lequel
l'étape de fabrication des parties réceptrices (63) consiste en outre à fabriquer les parties réceptrices (63) ayant une géométrie configurée pour recevoir les objets (64) et l'étape de positionnement de l'ensemble des objets dans les parties réceptrices (63) correspondantes, consiste en outre à engager une région périphérique de chaque objet (64) avec une région périphérique de la partie réceptrice (63) respective.

8. Procédé de fabrication d'un élément de construction (41) selon l'une quelconque des revendications précédentes,
selon lequel
avant de couvrir au moins une partie du moule (60) et l'ensemble des objets (64) avec de la matière durcissable, le procédé consiste en outre à fixer au moins une nappe (86) sur au moins deux objets (64).

9. Procédé de fabrication d'un élément de construction (41) selon l'une quelconque des revendications précédentes,
selon lequel
fabriquer sélectivement le matériau construit consiste en outre à déposer sélectivement et à meuler sélectivement le matériau construit.

10. Procédé de fabrication d'un élément de construction (41) selon l'une quelconque des revendications précédentes,
selon lequel
le procédé consiste en outre à chauffer au moins une partie du moule (60), à une température supérieure au point de fusion du matériau de construction pour faire fondre au moins cette partie du moule (60) et exposer au moins une partie du moule (60) a un liquide configuré pour dissoudre au moins cette partie du moule (60) en enlevant ainsi au moins cette partie du moule (60) de l'élément de construction composite (41).

11. Procédé de fabrication d'un élément de construction (41) selon la revendication 10,
selon lequel
le procédé consiste en outre à collecter le matériau de construction fondu et recycler par l'appareil (1) ce matériau de construction fondu, collecté.

12. Procédé de fabrication d'un élément de construction (41) selon l'une quelconque des revendications précédentes,
selon lequel
le matériau de construction est un composé de cire.

13. Procédé de fabrication d'un élément de construction (41) selon l'une quelconque des revendications précédentes,
selon lequel
l'étape de couverture d'au moins une partie d'une ou de plusieurs surfaces de coulées (61) non planes et l'ensemble des objets (64) avec la matière durcissable consiste en outre à au moins déverser la matière durcissable dans le moule (60) et l'ensemble des objets (64) et à pulvériser la matière durcissable sur le moule (60) et sur l'ensemble des objets (64).

14. Procédé de fabrication d'un élément de construction (41) selon la revendication 13,
selon lequel
l'étape de recouvrement par pulvérisation d'au moins une partie d'une ou de plusieurs surfaces de coulées non planes (61) et l'ensemble des objets (64) avec la matière durcissable consiste en outre à pulvériser une première matière durcissable pour former une première couche et pulvériser une seconde matière durcissable pour former une seconde couche.

15. Procédé de fabrication d'un élément de construction (41) selon la revendications 14,
selon lequel
la première matière durcissable est une matière composite et la seconde matière durcissable est une matière à base de ciment.
